# EUROPÄISCHE PATENTANMELDUNG

(11) **EP 4 699 742 A1**
(43) Veröffentlichungstag der Anmeldung: **25.02.2026**
(21) Anmeldenummer: 25191964.3
(22) Anmeldetag: 25.07.2025
(51) Int. Cl.: B24B 49/02

(54) **VORRICHTUNG ZUM SCHLEIFEN VON LASERDIODEN, VERFAHREN ZUM SCHLEIFEN VON LASERDIODEN SOWIE STEUEREINRICHTUNG**

(30) Priorität: 13.08.2024 DE 102024123115
(71) Anmelder: Thales Deutschland GmbH, 71254 Ditzingen (DE)
(72) Erfinder: Nack, Andreas, 22297 Hamburg (DE); Zorn, Arne, 25492 Heist (DE); Apel, Carsten, 23611 Sereetz (DE); Farkas, Uwe, 22549 Hamburg (DE)
(74) Vertreter: DREISS Patentanwälte PartG mbB

(57) **Zusammenfassung**

Eine Vorrichtung (10) zum Schleifen von Laserdioden umfasst: eine Schleifvorrichtung (14) mit einem Schleifbereich (30), der in einer Schleifebene (26) liegt; einen Diodenhalter (28), mittels dem mindestens eine Laserdiode im Schleifbereich (30) angeordnet werden kann; eine Einstelleinrichtung (32), mittels der ein Abstand zwischen Diodenhalter (28) und Schleifebene (26) eingestellt werden kann; und ein Kamerasystem (38) mit einer Sichtachse (44), wobei die Sichtachse (44) in einem Abstand (48) zu dem Schleifbereich (30) und wenigstens ungefähr in der Schleifebene (26) angeordnet ist; und eine Bewegungseinrichtung (50), mit der der Diodenhalter (28) parallel zu der Schleifebene (26) von einer ersten Position im Bereich des Schleifbereichs (30) zu einer zweiten Position im Bereich der Sichtachse (44) und zurück bewegbar ist.

## Beschreibung

Die vorliegende Erfindung betrifft eine Vorrichtung zum Schleifen von Laserdioden, ein Verfahren zum Schleifen von Laserdioden sowie eine Steuereinrichtung für eine Vorrichtung zum Schleifen von Laserdioden nach den Oberbegriffen der nebengeordneten Ansprüche.

Laserdioden sind grundsätzlich vom Markt her bekannt. Bei Ihnen handelt es sich um ein Halbleiter-Bauteil, welches ähnlich zu einer Leuchtdiode ist, welches jedoch Laserstrahlung erzeugt. Hierzu verfügen Laserdioden über einen p-n-Übergang mit starker Dotierung, der mit hohen Stromdichten betrieben wird. Um eine maximale Ausgangsleistung erzielen zu können, sollten die elektrischen Komponenten der Laserdiode in einem sehr genau definierten Abstand von einer Oberfläche eines Trägermaterials angeordnet sein, an dem die elektrischen Komponenten befestigt sind. Hierzu wird das Trägermaterial bisher manuell durch Schleifen abgetragen, bis der gewünschte Abstand vorliegt.

Die auf diese Weise hergestellten sehr leistungsstarken Laserdioden können beispielsweise in Waffensimulatoren eingesetzt werden. In solchen Waffensimulatoren werden Simulationswaffen verwendet, die bei einer Betätigung kein Geschoss, sondern einen Laserstrahl auf ein Ziel abgeben. Dieser Laserstrahl wird bevorzugt mit einer Laserdiode erzeugt.

Aufgabe der vorliegenden Erfindung ist es, die Herstellung von Laserdioden zu verbessern.

Diese Aufgabe wird durch eine Vorrichtung, ein Verfahren und eine Steuereinrichtung mit den Merkmalen der nebengeordneten Ansprüche gelöst. Vorteilhafte Weiterbildungen sind in Unteransprüchen genannt.

Ein Vorteil der Erfindung besteht darin, dass durch sie das Trägermaterial besonders genau abgetragen werden kann, sodass der Abstand der elektrischen Komponenten von der Oberfläche des Trägermaterials sehr genau eingestellt und damit die Ausgangsleistung der Laserdiode maximiert werden kann. Darüber hinaus wird die Einstellung des richtigen Abstands vereinfacht und beschleunigt, und hierdurch werden Kosten gespart. Außerdem wird die Reproduzierbarkeit verbessert und Ausschuss reduziert.

Konkret wird eine Vorrichtung zum Schleifen von Laserdioden vorgeschlagen, welche eine Schleifvorrichtung mit einem Schleifbereich, der in einer Schleifebene liegt, umfasst. Als Schleifen wird hierbei das typische spanende Fertigungsverfahren verstanden, bei dem Material in Form von Spänen durch ein Schleifwerkzeug abgetrennt wird. Typischerweise bewegt sich das Schleifwerkzeug mit einer Oberfläche relativ zum stationären Werkstück, und die Bewegung erfolgt parallel zu einer Ebene, nämlich der Schleifebene. Zur Abtrennung des Materials dienen dabei typischerweise mikroskopisch kleine, harte, mineralische Kristalle im Schleifwerkzeug. Der Schleifbereich entspricht dem Kontaktbereich zwischen dem Werkstück (hier also der Oberfläche des Trägermaterials der Laserdiode) und dem Schleifwerkzeug während des Schleifvorgangs.

Zu der Vorrichtung gehört auch ein Diodenhalter. Dieser hält die Laserdiode so, dass diese mit dem Trägermaterial zum Schleifwerkzeug hin und somit im Schleifbereich angeordnet werden kann. Typischerweise ist der Diodenhalter während des Schleifvorgangs zumindest in den Richtungen parallel zur Schleifebene stationär. Ferner umfasst die Vorrichtung eine Einstelleinrichtung, mittels der ein Abstand zwischen Diodenhalter und Schleifebene eingestellt werden kann. Auf diese Weise kann die Menge des abgetragenen Materials und letztlich der Abstand zwischen den elektrischen Komponenten und der Oberfläche des Trägermaterials eingestellt werden. Dies kann vor dem Schleifvorgang erfolgen oder sukzessive während des Schleifvorgangs, bis der gewünschte Wert erreicht ist. Dabei sei an dieser Stelle darauf hingewiesen, dass der Begriff "Einstelleinrichtung" bzw. "Einstellen" nicht zwingend bedeutet, dass ein präziser numerischer Wert für den Abstand eingestellt werden kann, sondern beispielsweise auch bedeutet, dass der Abstand in einem gewünschten Umfang ungefähr verändert werden kann.

Ferner umfasst die Vorrichtung ein Kamerasystem mit einer Sichtachse. Typischerweise ist die Sichtachse im Bereich der Mitte des Sichtfelds einer Kamera des Kamerasystems, in dem die Auflösung der Kamera maximal ist. Die Sichtachse ist sowohl in einem Abstand zu dem Schleifbereich als auch wenigstens ungefähr in der Schleifebene angeordnet. Die Sichtachse beobachtet somit nicht den Schleifbereich der Schleifvorrichtung, sondern einen neben dem Schleifbereich in dessen Schleifebene liegenden Bereich. Zu dem Kamerasystem kann auch ein Monitor gehören. Mit dem Kamerasystem kann der genaue Ort der elektrischen Komponenten auf bzw. im Trägermaterial erfasst werden, und dies kann dann beispielsweise auf dem Monitor dargestellt werden.

Mittels einer Bewegungseinrichtung der Vorrichtung kann der Diodenhalter bewegt werden. Die Bewegung des Diodenhalters erfolgt dabei exakt parallel zu der Schleifebene. Durch die Bewegungseinrichtung kann der Diodenhalter von einer ersten Position, in der er sich im Bereich des Schleifbereichs befindet, zu einer zweiten Position, in der er sich im Bereich der Sichtachse der Kamera befindet, und auch wieder zurück bewegt werden. In der ersten Position des Diodenhalters befindet sich die vom Diodenhalter gehaltene Laserdiode typischerweise mit der freien Oberfläche des Trägermaterials im Schleifbereich. In der zweiten Position des Diodenhalters befindet sich die vom Diodenhalter gehaltene Laserdiode typischerweise mit der freien Oberfläche des Trägermaterials mindestens ungefähr in der Sichtachse der Kamera. Dabei ist die Sichtachse parallel und mehr oder weniger tangential oder in geringem Abstand zu dieser freien Oberfläche ausgerichtet.

Bei einer Weiterbildung ist vorgesehen, dass mittels der Einstelleinrichtung die Position des Diodenhalters orthogonal zur Schleifebene eingestellt werden kann. Dies gestattet einen präzisen Abtrag von Material. Grundsätzlich denkbar ist aber auch eine Bewegungsrichtung schräg zur Schleifebene.

Bei einer Weiterbildung hierzu ist vorgesehen, dass die Einstelleinrichtung zur Einstellung eine motorische Antriebseinrichtung aufweist. Eine solche motorische Antriebseinrichtung kann beispielsweise einen elektrischen Antriebsmotor und eine Antriebsspindel umfassen. Mittels einer solchen motorischen Antriebseinrichtung wird die Benutzung der erfindungsgemäßen Vorrichtung vereinfacht, und sie ermöglicht gegebenenfalls sogar eine Automatisierung des Schleifvorgangs. Beispielsweise kann durch Bilderkennung mittels der Kamera die durch den Schleifvorgang abzutragende optimale Materialstärke ermittelt werden, und entsprechend kann dann der Diodenhalter mittels der Einstelleinrichtung relativ zum Schleifbereich positioniert werden.

Bei einer Weiterbildung ist vorgesehen, dass die Bewegungseinrichtung eine Linearführung, insbesondere eine Gleitschiene, umfasst, die parallel zur Schleifebene angeordnet ist. Hierdurch wird eine Bewegung des Diodenhalters exakt parallel zur Schleifebene auf einfache Art und Weise ermöglicht.

Bei einer Weiterbildung hierzu ist vorgesehen, dass die Bewegungseinrichtung zur Bewegung eine motorische Antriebseinrichtung aufweist. Dies gestattet eine weitere Vereinfachung bei der Handhabung der erfindungsgemäßen Vorrichtung und auch eine weitere Automatisierung.

Bei einer Weiterbildung ist vorgesehen, dass die Schleifvorrichtung eine Schleifscheibe aufweist. Eine solche ist robust und gestattet einen präzisen Materialabtrag.

Konkret wird auch ein Verfahren zum Schleifen von Laserdioden mittels einer Vorrichtung nach einem der vorhergehenden Aspekte vorgeschlagen, welches folgende Schritte umfasst: a. Positionieren einer Laserdiode in der Sichtachse des Kamerasystems; b. Anpassen der Position der Laserdiode relativ zur Schleifebene; c. Bewegen der Laserdiode zum Schleifbereich; d. Durchführen eines Schleifvorgangs. Es versteht sich, dass der Schritt b auch während des Schritts d durchgeführt werden kann.

Bei einer Weiterbildung hierzu ist vorgesehen, dass das Verfahren ferner folgende Schritte umfasst: e. nach dem Schritt d: Bewegen der Laserdiode zurück in die Sichtachse des Kamerasystems; f. gegebenenfalls: nochmalige Durchführung der Schritte b-d.

Konkret wird auch eine Steuereinrichtung vorgeschlagen, umfassend einen Prozessor und einen Speicher für Programmcode, welche zur Ausführung eines Verfahrens nach wenigstens einem der obigen Aspekte ausgebildet ist. Gegebenenfalls kann durch die Steuereinrichtung ein vollautomatischer Betrieb der erfindungsgemäßen Vorrichtung ermöglicht werden. Die Steuereinrichtung kann dabei Teil der erfindungsgemäßen Vorrichtung sein. Beispielsweise kann die Steuereinrichtung ein Computer sein.

Nachfolgend wird die Erfindung unter Bezugnahme auf die beigefügte Zeichnung erläutert. In der Zeichnung zeigen:
- Figur 1: eine schematische Seitenansicht einer Vorrichtung zum Schleifen von Laserdioden; und
- Figur 2: ein Flussdiagramm eines Verfahrens zum Betreiben der Vorrichtung von Figur 1.

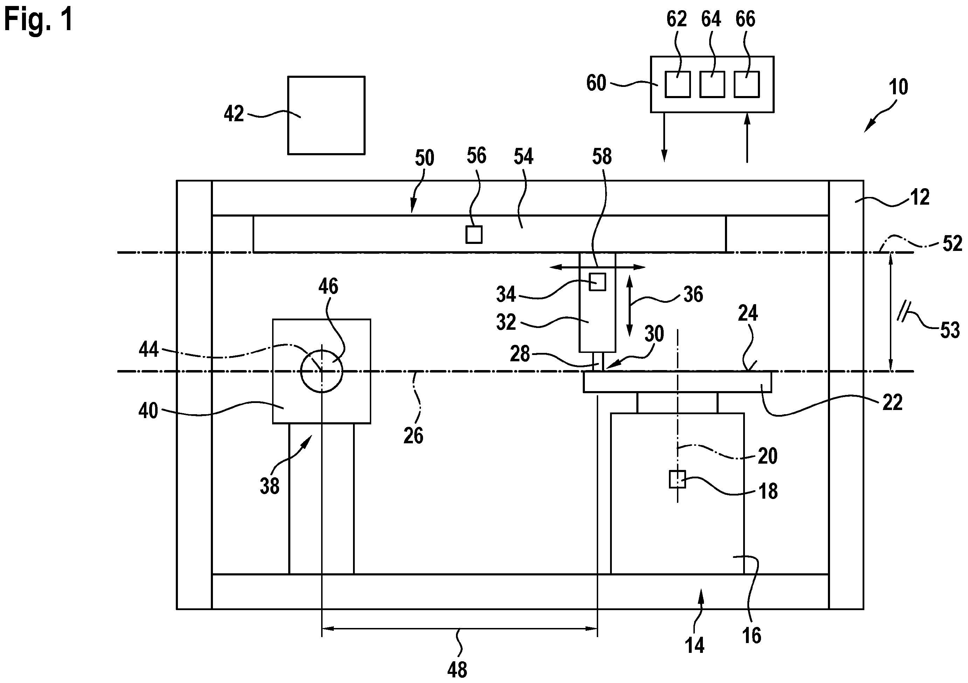

Eine Vorrichtung zum Schleifen von Laserdioden trägt in Figur 1 insgesamt das Bezugszeichen 10. Sie umfasst einen starren und festen Rahmen 12, in und an dem verschiedene Komponenten der Vorrichtung 10 angeordnet und befestigt sind. So gehört zu der Vorrichtung 10 eine Schleifvorrichtung 14, die vorliegend ein Motorgehäuse 16 mit einem vorliegend nur schematisch angedeuteten elektrischen Antriebsmotor 18 und eine vorliegend beispielhaft vertikale Antriebsachse 20 aufweist, sowie ein Schleifwerkzeug vorliegend beispielhaft in Form einer Schleifscheibe 22, die von dem Antriebsmotor 18 in Rotation um die Antriebsachse 20 versetzt werden kann.

Eine vorliegend beispielhaft obere Stirnseite 24 der Schleifscheibe 22 definiert eine durch eine strichpunktierte Linie angedeutete Schleifebene 26. Die Schleifscheibe 22 umfasst mikroskopisch kleine, harte, mineralische Kristalle, durch die, wie nachfolgend noch erläutert werden wird, Material in Form von Spänen von einem Werkstück, vorliegend der Laserdiode, abgetragen werden kann.

Zu der Vorrichtung 10 gehört auch ein Diodenhalter 28. Dieser dient zur Halterung einer nicht gezeichneten Laserdiode so, dass diese mit dem Trägermaterial zur Stirnseite 24 der Schleifscheibe 22 hin angeordnet werden kann. Ein durch einen Pfeil angedeuteter Kontaktbereich zwischen dem Trägermaterial der Laserdiode und der Stirnseite 24 der Schleifscheibe 22 wird als Schleifbereich 30 bezeichnet.

Der Diodenhalter 28 ist an einer Einstelleinrichtung 32 angeordnet, die über einen motorischen Antrieb 34 verfügt. Beispielsweise mittels einer Antriebsspindel (nicht gezeichnet) kann auf diese Weise die in Figur 1 beispielhaft vertikale Position des Diodenhalters 28 bzw. die Position des Diodenhalters 26 orthogonal zur Schleifebene 26 verändert werden. Letztlich kann hierdurch ein Abstand zwischen dem Diodenhalter 28 und der Schleifebene 26 eingestellt werden. Die Bewegbarkeit des Diodenhalters 28 durch die Einstelleinrichtung 32 ist in Figur 1 durch einen Doppelpfeil 36 angedeutet.

In Figur 1 beispielhaft seitlich links von der Schleifvorrichtung 14 ist ein vorliegend beispielhaft stationäres Kamerasystem 38 angeordnet. Zu dem Kamerasystem 38 gehören eine Kamera 40 und vorliegend beispielhaft auch ein Monitor 42. Eine Sichtachse der Kamera 40 ist vorliegend orthogonal zur Ebene der Figur 1 und in Figur 1 mit dem Bezugszeichen 44 bezeichnet. Die Sichtachse 44 ist typischerweise im Bereich einer Mitte eines Sichtfelds 46 der Kamera 40 angeordnet. In der Mitte des Sichtfelds 46 ist die Auflösung der Optik der Kamera 40 typischerweise maximal. Die Sichtachse 44 ist somit sowohl in einem seitlichen Abstand 48 zu dem Schleifbereich 30 als auch in der Schleifebene 26 angeordnet.

Mittels einer Bewegungseinrichtung 50 der Vorrichtung 10 kann der Diodenhalter 28 zusammen mit der Einstelleinrichtung 32 vorliegend beispielhaft horizontal, also parallel zur Schleifebene 26 bewegt werden. Die Bewegungsebene der Bewegungseinrichtung 50 ist vorliegend durch eine strichpunktierte Linie 52 angedeutet, und diese ist exakt parallel zur Schleifebene 26 (Bezugszeichen 53). Hierzu verfügt die Bewegungseinrichtung 50 über eine Linearführung 54, die insbesondere als Gleitschiene ausgebildet sein kann oder eine solche umfassen kann, die parallel zur Schleifebene 26 angeordnet ist. Ferner verfügt die Bewegungseinrichtung 50 über eine motorische Antriebseinrichtung 56, durch die die Bewegung des Diodenhalters vorliegend beispielhaft in horizontaler Richtung bewirkt werden kann, was durch einen Doppelpfeil 58 angedeutet ist.

Durch die Bewegungseinrichtung 50 kann der Diodenhalter 28 von einer ersten Position, in der er sich im Bereich des Schleifbereichs 30 befindet (wie in Figur 1 dargestellt), zu einer zweiten Position, in der er sich im Bereich der Sichtachse 44 der Kamera 40 befindet, und auch wieder zurück bewegt werden. In der ersten Position des Diodenhalters 28 befindet sich die vom Diodenhalter 28 gehaltene Laserdiode typischerweise mit der freien Oberfläche des Trägermaterials im Schleifbereich 30 in Kontakt mit der Schleifscheibe 22. In der zweiten Position des Diodenhalters 28 befindet sich die vom Diodenhalter 28 gehaltene Laserdiode typischerweise mit der freien Oberfläche des Trägermaterials mindestens ungefähr in der Sichtachse 44 der Kamera 40.

Schließlich gehört zu der Vorrichtung 10 auch noch eine Steuereinrichtung 60 mit mindestens einem Prozessor 62 und mindestens einem Speicher 64 für Programmcode. Die Steuereinrichtung 60 umfasst auch ein HMI 66, beispielsweise einen Bildschirm und eine Tastatur. Bei der Steuereinrichtung 60 kann es sich beispielsweise um einen Computer handeln.

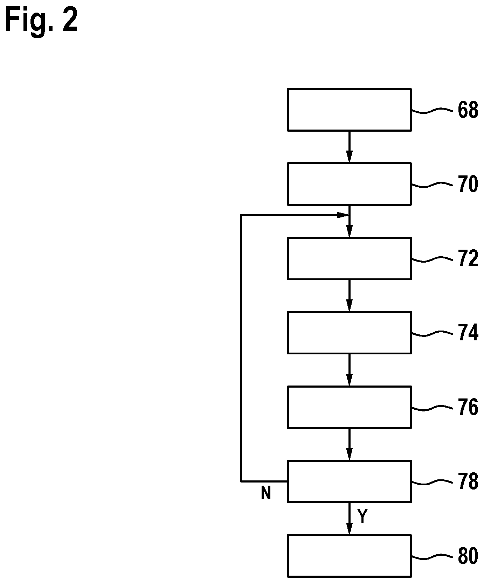

Der Betrieb der Vorrichtung 10 wird nun unter Bezugnahme auf Figur 2 erläutert, wobei das erläuterte Verfahren typischerweise von der Steuereinrichtung 60 zumindest zum Teil gesteuert wird, sodass ein mindestens halbautomatischer, vorzugsweise jedoch vollautomatischer Betrieb der Vorrichtung 10 ermöglicht wird.

Nach einem Start-Funktionsblock 68 wird in einem Funktionsblock 70 der Diodenhalter 28 mit der Laserdiode in der zweiten Position, also in der Sichtachse 44 des Kamerasystems 38 positioniert. Über das erfasste seitliche Bild vom Trägermaterial der Laserdiode wird nun bestimmt, wie viel Material vom Trägermaterial abgetragen werden soll. Wird erreicht, dass die elektrischen Komponenten innerhalb der Laserdiode einen definierten Abstand von der (freien) Oberfläche des Trägermaterials haben. Hierzu wird die exakte Position der elektrischen Komponenten innerhalb bzw. auf dem Trägermaterial durch das Kamerasystem 38 erfasst bzw. ermittelt, und dies kann beispielsweise auf dem Monitor 42 angezeigt werden.

Entsprechend wird in einem Funktionsblock 72 die Position des Diodenhalters 28 mit der Laserdiode gemäß dem vertikalen Doppelpfeil 36 durch den motorischen Antrieb der Einstelleinrichtung 32 angepasst. Nun wird der Diodenhalter 28 mit der Laserdiode in einem Funktionsblock 74 zum Schleifbereich 30 hinbewegt, und zwar mittels der Bewegungseinrichtung 50 entsprechend dem horizontalen Doppelpfeil 58, und ein Schleifvorgang mit rotierender Schleifscheibe 22 durchgeführt. Es versteht sich, dass die Anpassung der Position des Diodenhalters 28 gemäß dem vertikalen Doppelpfeil 36 auch während des Schleifvorgangs im Funktionsblock 74 erfolgen kann.

Danach wird der Diodenhalter 28 mit der nunmehr bearbeiteten Laserdiode in einem Funktionsblock 76 vom Schleifbereich 30 weg und wieder zur Sichtachse 44 des Kamerasystems 38 bewegt. Dabei bleibt die in Figur 1 beispielhaft vertikale Position des Diodenhalters 28 unverändert. Durch Auswertung des vom Kamerasystem 38 erfassten Bilds des Trägermaterials der Laserdiode wird in einem Funktionsblock 78 bestimmt, ob die Dicke des Trägermaterials und somit der Abstand der elektrischen Komponenten von der freien Oberfläche des Trägermaterials optimal ist. Ist dies der Fall, endet das Verfahren in einem Ende-Funktionsblock 80. Andernfalls erfolgt ein Rücksprung vor den Funktionsblock 72.

## Patentansprüche

1. Vorrichtung (10) zum Schleifen von Laserdioden, **dadurch gekennzeichnet, dass** sie umfasst: eine Schleifvorrichtung (14) mit einem Schleifbereich (30), der in einer Schleifebene (26) liegt; einen Diodenhalter (28), mittels dem mindestens eine Laserdiode im Schleifbereich (30) angeordnet werden kann; eine Einstelleinrichtung (32), mittels der ein Abstand zwischen Diodenhalter (28) und Schleifebene (26) eingestellt werden kann; und ein Kamerasystem (38) mit einer Sichtachse (44), wobei die Sichtachse (44) in einem Abstand (48) zu dem Schleifbereich (30) und wenigstens ungefähr in der Schleifebene (26) angeordnet ist; und eine Bewegungseinrichtung (50), mit der der Diodenhalter (28) parallel zu der Schleifebene (26) von einer ersten Position im Bereich des Schleifbereichs (30) zu einer zweiten Position im Bereich der Sichtachse (44) und zurück bewegbar ist.

2. Vorrichtung (10) nach Anspruch 1, **dadurch gekennzeichnet, dass** mittels der Einstelleinrichtung (32) die Position des Diodenhalters (28) orthogonal zur Schleifebene (26) eingestellt werden kann.

3. Vorrichtung (10) nach Anspruch 2, **dadurch gekennzeichnet, dass** die Einstelleinrichtung (32) zur Einstellung eine motorische Antriebseinrichtung (34) aufweist.

4. Vorrichtung (10) nach wenigstens einem der vorhergehenden Ansprüche, **dadurch gekennzeichnet, dass** die Bewegungseinrichtung (50) eine Linearführung (54), insbesondere eine Gleitschiene, umfasst, die parallel zur Schleifebene (26) angeordnet ist.

5. Vorrichtung (10) nach Anspruch 4, **dadurch gekennzeichnet, dass** die Bewegungseinrichtung (50) zur Bewegung eine motorische Antriebseinrichtung (56) aufweist.

6. Vorrichtung (10) nach wenigstens einem der vorhergehenden Ansprüche, **dadurch gekennzeichnet, dass** die Schleifvorrichtung (14) eine Schleifscheibe (22) aufweist.

7. Verfahren zum Schleifen von Laserdioden mittels einer Vorrichtung (10) nach einem der vorhergehenden Ansprüche, **dadurch gekennzeichnet, dass** es folgende Schritte umfasst:
a. Positionieren einer Laserdiode in der Sichtachse (44) des Kamerasystems (38);
b. Anpassen der Position der Laserdiode relativ zur Schleifebene (26);
c. Bewegen der Laserdiode zum Schleifbereich (30);
d. Durchführen eines Schleifvorgangs.

8. Verfahren nach Anspruch 7, **dadurch gekennzeichnet, dass** es ferner folgende Schritte umfasst:
e. nach dem Schritt d: Bewegen der Laserdiode zurück in die Sichtachse (44) des Kamerasystems (38);
f. gegebenenfalls: nochmalige Durchführung der Schritte b-d.

9. Steuereinrichtung (60), umfassend einen Prozessor (62) und einen Speicher (64) für Programmcode, **dadurch gekennzeichnet, dass** sie zur Ausführung eines Verfahrens nach wenigstens einem der Ansprüche 7 oder 8 ausgebildet ist.
